# EUROPÄISCHE PATENTSCHRIFT

(11) **EP 1 908 131 B1**
(45) Veröffentlichungstag und Bekanntmachung des Hinweises auf die Patenterteilung: **11.11.2009**
(21) Anmeldenummer: 06762839.6
(22) Anmeldetag: 26.07.2006
(51) Int. Cl.: H01L 41/083, H01L 41/24

(54) **VERFAHREN ZUM HERSTELLEN EINES MONOLITHISCHEN PIEZOAKTORS MIT TEILSTAPELN, MONOLITHISCHER PIEZOAKTOR MIT TEILSTAPELN UND VERWENDUNG DES PIEZOAKTORS**
METHOD FOR PRODUCING A MONOLITHIC PIEZO ACTUATOR WITH STACK ELEMENTS, MONILITHIC PIEZO ACTUATOR WITH STACK ELEMENTS, AND USE OF THE PIEZO ACTUATOR
PROCEDE DE FABRICATION D'UN ACTIONNEUR PIEZOELECTRIQUE MONOLITHIQUE A SECTIONS D'EMPILEMENT, ACTIONNEUR PIEZOELECTRIQUE MONOLITHIQUE A SECTIONS D'EMPILEMENT ET UTILISATION DUDIT ACTIONNEUR PIEZOELECTRIQUE

(30) Priorität: 26.07.2005 DE 102005034814
(43) Veröffentlichungstag der Anmeldung: 09.04.2008
(73) Patentinhaber: SIEMENS AKTIENGESELLSCHAFT, 80333 München (DE)
(72) Erfinder: SCHUH, Carsten, 85598 Baldham (DE); ZUMSTRULL, Claus, 93128 Regenstauf (DE)
(86) Internationale Anmeldenummer: PCT/EP2006/007405
(87) Internationale Veröffentlichungsnummer: WO 2007/012484

(56) Entgegenhaltungen:
- WO-A-2006/077245
- DE-A1- 10 307 825
- DE-A1- 19 928 178
- DE-A1-102004 012 282
- DE-A1-102004 026 572

## Beschreibung

Die Erfindung betrifft ein Verfahren zum Herstellen eines monolithischen Piezoaktors, der übereinander angeordnete Teilstapel aufweist. Daneben werden ein monolithischer Piezoaktor und eine Verwendung des Piezoaktors angegeben.

Es sind Piezoaktoren bekannt, die aus einer Mehrzahl übereinander angeordneter Teilstapel bestehen. Jeder der Teilstapel weist übereinander angeordnete Piezokeramikschichten aus einem piezokeramischen Werkstoff und zwischen den Piezokeramikschichten angeordnete Elektrodenschichten (Innenelektroden) auf. Bei monolithischen, d.h. einstückigen Piezoaktoren wird die gesamte Anordnung aus Piezokeramikschichten und Elektrodenschichten in einem gemeinsamen Sinterprozess gewonnen. Es resultiert ein monolithischer, aus Teilstapeln aufgebauter Gesamtstapel.

Bei der erstmaligen elektrischen Ansteuerung solcher Piezoaktoren bis in den Großsignalbereich (Feldstärken von mehreren kV/mm) wird der piezokeramische Werkstoff gepolt. Dabei resultiert eine irreversible Längenänderung, die so genannte remanente Dehnung. Aufgrund der remanenten Dehnung und.aufgrund einer zusätzlichen Dehnung, die bei elektrischer Ansteuerung der Elektrodenschichten im Betrieb des Piezoaktors auftritt, entstehen im Gesamtstapel Zugspannungen. Diese Zugspannungen führen dazu, dass im Verlauf der Polung oder im Betrieb des Piezoaktors beispielsweise entlang einer Grenzfläche zwischen einer Piezokeramikschicht und einer Elektrodenschicht Risse (Polungsrisse) entstehen. Besonders schädlich sind dabei sich verzweigende oder sich in Längsrichtung des Gesamtstapels ausbreitende Risse. Solche Risse führen unweigerlich zu vorzeitigem Ausfall des Piezoaktors.

Aufgabe der Erfindung ist es, in den bekannten Piezoaktor gezielt Entlastungsrisse einzubringen, so dass sowohl bei der Polung als auch im Betrieb keine hohen Zugspannungen auftreten, die zur Bildung oben beschriebener Polungsrisse führen könnten.

Zur Lösung der Aufgabe wird ein Verfahren zum Herstellen eines Piezoaktors in monolithischer Vielschichtbauweise angegeben, aufweisend einen Teilstapel und mindestens einen weiteren Teilstapel, wobei jeder der Teilstapel übereinander angeordnete Piezokeramikschichten und zwischen den Piezokeramikschichten angeordnete Elektrodenschichten aufweist, sich jede der Elektrodenschichten des jeweiligen Teilstapels an mindestens einen von mindestens zwei seitlichen Oberflächenabschnitten des Teilstapels erstreckt, an den seitlichen Oberflächenabschnitten des jeweiligen Teilstapels Außenmetallisierungen derart angeordnet und mit den Elektrodenschichten des Teilstapels verbunden sind, dass übereinander benachbart angeordnete Elektrodenschichten des Teilstapels mittelbar über die Außenmetallisierungen mit unterschiedlichen elektrischen Potentialen beaufschlagt werden können, die Teilstapel übereinander zu einem monolithischen Gesamtstapel angeordnet sind, und die Teilstapel mit Hilfe mindestens einer zwischen den Teilstapeln angeordneten Verbindungsschicht miteinander verbunden sind. Das Verfahren weist folgende Verfahrensschritte auf: a) Bereitstellen des Gesamtstapels und b) Erzeugen eines Entlastungsrisses der Verbindungsschicht, wobei die Entlastungsrisse gemäß dem kennzeichnenden Teil des Ansprüche 1 und 4 erzeugt werden. Zum Bereitstellen des Gesamtstapels können die Außenmetallisierungsbereiche durch strukturiertes Aufbringen von elektrisch leitendem Material erzeugt werden. Denkbar ist auch, dass zunächst eine geschlossene Außenmetallisierung aus elektrisch leitendem Material aufgebracht wird. Durch Entfernen bestimmter Stellen der Aussenmetallisierung entstehen die elektrisch voneinander isolierten Außenmetallisierungsbereiche.

Zur Lösung der Aufgabe wird auch ein Piezoaktor in monolithischer Vielschichtbauweise angegeben, aufweisend einen Teilstapel und mindestens einen weiteren Teilstapel, wobei jeder der Teilstapel übereinander angeordnete Piezokeramikschichten und zwischen den Piezokeramikschichten angeordnete Elektrodenschichten aufweist, sich jede der Elektrodenschichten des jeweiligen Teilstapels an mindestens einen von mindestens zwei seitlichen Oberflächenabschnitten des Teilstapels erstreckt, an den seitlichen Oberflächenabschnitten des jeweiligen Teilstapels Außenmetallisierungen derart angeordnet und mit den Elektrodenschichten des Teilstapels verbunden sind, dass übereinander benachbart angeordnete Elektrodenschichten des Teilstapels mittelbar über die Außenmetallisierungen mit unterschiedlichen elektrischen Potentialen beaufschlagt werden können, die Teilstapel übereinander zu einem monolithischen Gesamtstapel angeordnet sind und die Teilstapel mit Hilfe mindestens einer zwischen den Teilstapeln angeordneten Verbindungsschicht miteinander verbunden sind. Der Piezoaktor ist **dadurch gekennzeichnet, dass** die Verbindungsschicht einen Entlastungsriss aufweist, die Außenmetallisierungen der Teilstapel Außenmetallisierungsbereiche des Gesamtstapels bilden, die durch die Verbindungsschicht voneinander getrennt sind, und Außenmetallisierungsbereiche, mit deren Hilfe Elektrodenschichten der Teilstapel mit gleichen elektrischen Potentialen beaufschlagt werden sollen, über ein elektrisches Überbrückungsmittel elektrisch leitend miteinander verbunden sind.

Die Verbindungsschicht ist eine der Schichten des bzw. der Teilstapel. Beispielsweise ist die Verbindungsschicht eine der Piezokeramikschichten. Die Verbindungsschicht kann aber auch von einer Elektrodenschicht gebildet sein. Der Entlastungsriss kann in der Verbindungsschicht verlaufen. Bevorzugt entsteht der Entlastungsriss an einer Grenzfläche zwischen der Verbindungsschicht und einer benachbarten Schicht.

Die zugrunde liegende Idee der Erfindung besteht darin, ein definiertes Zug-/Druckspannungsprofil im Gesamtstapel zu erzeugen. Aufgrund des definierten Zug-/Druckspannungsprofils entstehen Entlastungsrisse an bestimmten Stellen des Gesamtstapels, nämlich an den Grenzen zwischen den Teilstapeln. An diesen Stellen werden Polungsrisse induziert und vorangetrieben. Die induzierten Polungsrisse führen während der Polung und während des Betriebs zu einer Reduzierung von Maxima des Zug-/Druckspannungsprofils im Gesamtstapel. Es treten im Gesamtstapel mit den Entlastungsrissen Zug-/Druckspannungen auf, die niedriger sind, als die Zug-/Druckspannungen in einem Gesamtstapel ohne die Entlastungsrisse. Als Folge ist die Wahrscheinlichkeit für die Bildung weiterer Risse reduziert. Es kommt zu keiner unkontrollierten Bildung und zu keinem unkontrollierten Wachstum von Rissen.

Die induzierten Entlastungsrisse pflanzen sich in der Regel parallel zu den Elektrodenschichten und den Piezokeramikschichten in Richtung Oberfläche bzw. Oberflächenabschnitt des Gesamtstapels fort. Dies kann zu einer Unterbrechung der am Oberflächenabschnitt angebrachten Außenmetallisierung führen. Dadurch, dass die Entlastungsrisse definiert eingebracht werden, sind auch die Stellen bekannt, an denen die Außenmetallisierung mit hoher Wahrscheinlichkeit unterbrochen wird. Durch die Unterbrechung bilden sich Außenmetallisierungsbereiche. Mit Hilfe des elektrischen Überbrückungsmittels wird die elektrische Unterbrechung überwunden. Das Überbrückungsmittel fungiert als externe Elektrode. Die mit dem Überbrückungsmittel kontaktierten Außenmetallisierungsbereiche sind elektrisch leitend miteinander verbunden und können daher mit den gleichem elektrischen Potential beaufschlagt werden. Ein dafür geeignetes Überbrückungsmittel ist beispielsweise ein an den Außenmetallisierungsbereichen angelöteter Bonddraht. Andere Überbrückungsmittel, beispielsweise ein dünnes Blech, eine Metallbahn oder ein Drahtgeflecht sind ebenfalls denkbar.

Gemäß einer von zwei Ausgestaltungen werden zum Erzeugen des Entlastungsrisses folgende weiteren Verfahrensschritte durchgeführt: c) Polarisieren des Teilstapels und d) Polarisieren des weiteren Teilstapels. Es wird zunächst nur einer der Teilstapel polarisiert. Dazu werden nur die Elektrodenschichten des zu polarisierenden Teilstapels elektrisch angesteuert. Die Elektrodenschichten des anderen Teilstapels werden mit dem gleichen Potential (z.B. Masse) beaufschlagt. Vorzugsweise werden daher während des Polarisierens des Teilstapels die Elektrodenschichten des weiteren Teilstapels kurz geschlossen. Aufgrund der Längenänderung, die durch die Polarisierung nur des Teilstapels auftritt, kommt es an der Verbindungsschicht zwischen dem Teilstapel und dem weiteren Teilstapel zu sehr hohen Zugspannungen. Aufgrund dieser Zugspannung bildet sich der Entlastungsriss. Anschließend wird der weitere Teilstapel polarisiert. Während des Polarisierens des weiteren Teilstapels werden die Elektrodenschichten des Teilstapels kurzgeschlossen.

Gemäß der weiteren Ausgestaltung werden zum Erzeugen des Entlastungsrisses folgende weiteren Verfahrensschritte durchgeführt: e) Polarisieren des Gesamtstapels und f) Depolarisieren eines der Teilstapel. Es wird zunächst der Gesamtstapel polarisiert. Danach wird einer der Teilstapel depolarisiert. Dies führt zu einer Längenänderung des Teilstapels. Wieder kommt es zu mechanischen Zugspannungen, die zu einem Entlastungsriss der Verbindungsschicht führen.

Die beschriebenen Polarisierungsschritte können zu einer nahezu vollständigen Polarisierung des piezokeramischen Werkstoffs führen. Beispielsweise betrifft dies den Verfahrensschritt e) mit dem Polarisieren des Gesamtstapels. Es kann aber nur eine teilweise Polarisierung vorgesehen sein. Daher wird gemäß einer weiteren Ausgestaltung zum Polarisieren des Teilstapels und/oder zum Polarisieren des weiteren Teilstapels ein Teilpolarisieren durchgeführt.

Während der einzelnen Polarisierungsschritte können beliebige Parameter variiert werden, die die Bildung des Entlastungsrisses begünstigen oder das Einbringen des Entlastungsrisses an einer definierten Stelle erleichtern. Beispielsweise wird während des Polarisierens ein Temperaturgradient im Gesamtstapel erzeugt. Vorzugsweise wird aber während des Polarisierens des Teilstapels und/oder während des Polarisierens des weiteren Teilstapels und/oder während des Polarisierens des Gesamtstapels und/oder während des Depolarisierens eines der Teilstapel eine Druckspannung am Gesamtstapel angelegt. Die angelegte Druckspannung beeinflusst die während des Polarisierens bzw. Depolarisierens erzeugte Längenänderung und damit die Bildung des Entlastungsrisses. Der Stapel wird vorgespannt. Ein Vorspannungsdruck kann dabei bis zu 50 MPa betragen. Die Vorspannung erfolgt uniaxial in Stapelrichtung. Isostatische Druckanwendung ist ebenfalls möglich.

Durch die Verbindungsschicht mit dem Entlastungsriss ist der Gesamtstapel des Piezoaktors in mindestens zwei Teilstapel unterteilt. Dadurch, dass eine Unterteilung des gesamten Stapels in kleinere Teilstapel erfolgt, treten bei der elektrischen Ansteuerung des Piezoaktors automatisch geringere mechanische Spannungen auf.

Mindestens einer der Teilstapel weist dabei eine aus dem Bereich von einschließlich 1 mm bis einschließlich 10 mm und insbesondere eine aus dem Bereich von einschließlich 3 mm bis einschließlich 5 mm ausgewählte Teilstapelhöhe auf. Innerhalb dieser Grenzen lassen sich mechanische Spannungen, die durch die elektrische Ansteuerung der Elektrodenschichten entstehen, sehr gut handhaben. Gleichzeitig sind aber ein relativ hoher Stapel und damit eine relativ hohe Auslenkung des Piezoaktors möglich. Insbesondere ist dabei ein Gesamtstapel mit einer Stapelhöhe zugänglich, die aus dem Bereich von einschließlich 10 mm bis einschließlich 200 mm ausgewählt ist. Es resultiert ein Gesamtstapel, der über eine hohe Auslenkung, eine ausreichende Kraftübertragung und trotz Entlastungsriss eine sehr hohe Steifigkeit verfügt.

Mit der Erfindung ist ein neuer, zuverlässiger Piezoaktor zugänglich. Dieser neue Piezoaktor wird bevorzugt zur Ansteuerung eines Ventils und insbesondere eines Einspritzventils einer Brennkraftmaschine verwendet. Die Brennkraftmaschine ist beispielsweise ein Motor eines Kraftfahrzeugs.

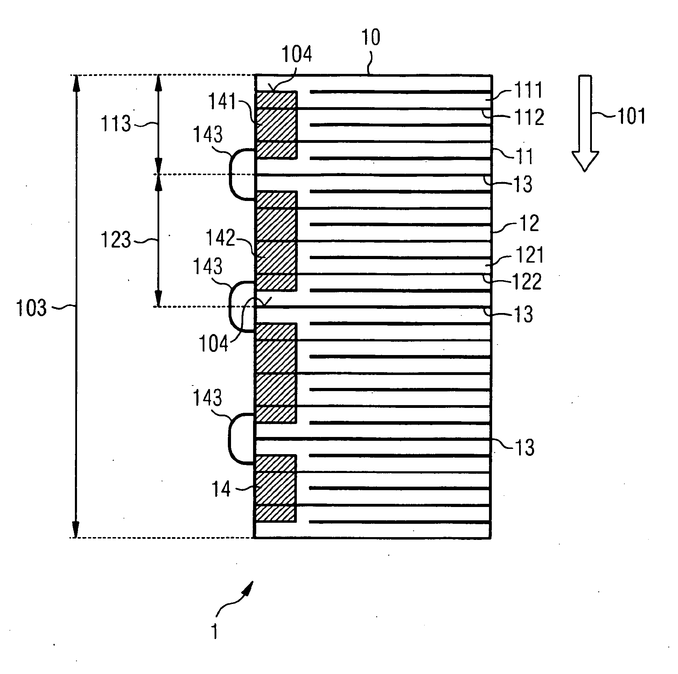

Anhand eines Ausführungsbeispiels und der dazugehörigen Figur wird die Erfindung im Folgenden näher erläutert. Die Figur ist schematisch und stellt keine maßstabsgetreue Abbildung dar.

Die Figur zeigt einen Piezoaktor in Vielschichtbauweise mit mehreren Teilstapeln.

Der Piezoaktor 1 ist ein Piezoaktor mit einem Stapel (Gesamtstapel) 10 in monolithischer Vielschichtbauweise. Der Piezoaktor 1 besteht aus einem Teilstapel 11 und mindestens einem weiteren Teilstapel 12. Die Teilstapel sind übereinander angeordnet. Zwischen den Teilstapeln befindet sich eine Verbindungsschicht 13 mit einem nicht gezeigten Entlastungsriss. Die Verbindungsschicht 13 ist eine elektrisch nicht kontaktierte Elektrodenschicht. Alternativ dazu ist die Verbindungsschicht 13 eine piezokeramische Schicht. Die Gesamthöhe 103 des Gesamtstapels 10 in Stapelrichtung 101 beträgt 30 mm. Die Teilstapelhöhe 113 und 123 der Teilstapel 113 und 123 beträgt jeweils etwa 2 mm.

Jeder der Teilstapel 11 und 12 besteht aus Piezokeramikschichten 111 beziehungsweise 121 aus PZT und Elektrodenschichten 112 beziehungsweise 122 aus Kupfer. In alternativen Ausführungsformen bestehen die Elektrodenschichten aus Silber beziehungsweise aus einer Silber-Palladium-Legierung. Im Gesamtstapel 10 beziehungsweise in den Teilstapeln 11 und 12 benachbarte Elektrodenschichten sind an unterschiedliche Seitenbereiche des Gesamtstapels 10 beziehungsweise der Teilstapel 11 und 12 geführt. Dort ist zur elektrischen Kontaktierung der Elektrodenschichten jeweils eine Metallisierung 14 angebracht. In der Figur ist eine der Metallisierungen 14 angedeutet. Die Metallisierung 14 weist zwei Metallisierungsbereiche 141 und 142 für jeweils einen der Teilstapel 11 und 12 auf. Die Metallisierungsbereiche 141 und 142 sind über ein elektrisches Überbrückungsmittel 143 in Form eines angelöteten Drahts elektrisch leitend miteinander verbunden.

Zum Herstellen des Piezoaktors 1 bzw. des Gesamtstapels 10 des Piezoaktors 1 werden keramische Grünfolien mit Elektrodenmaterial bedruckt, übereinander gestapelt und unter einachsigem Druck laminiert. Anschließend wird der so erhaltene "grüne" Stapel entbindert und gesintert. Dieser Temperaturbehandlungsschritt (Cofiring) führt zum monolithischen Gesamtstapel 10. Anschließend wird an den Oberflächenabschnitten 104 des Gesamtstapels die Außenmetallisierung 14 aufgebracht. Gemäß einer ersten Ausführungsform wird die Metallisierung auf dem gesamten Oberflächenabschnitt 104 aufgebracht und anschließend durch Entfernen der Metallisierung in Außenmetallisierungsbereiche 141 und 142 unterteilt. Diese Außenmetallisierungsbereiche sind elektrisch voneinander isoliert und können individuell elektrisch angesteuert werden. Alternativ dazu wird die Außenmetallisierung strukturiert aufgebracht. D.h. die Außenmetallisierung wird in Form der voneinander elektrisch isolierten Außenmetallisierungsbereiche aufgebracht. Ein nachträgliches Entfernen der Metallisierung zur Bildung der Außenmetallisierungsbereiche ist nicht nötig.

Ein auf diese oder ähnliche Weise hergestellter Gesamtstapel 10 wird anschließend gepolt. Dazu werden nur die Elektrodenschichten 112 des Teilstapels 11 elektrisch angesteuert. Die Elektrodenschichten 122 des weiteren Teilstapels 12 werden kurzgeschlossen. Durch die elektrische Ansteuerung der Elektrodenschichten 122 des Teilstapels 11 kommt es nur zu einer Längenänderung dieses Teilstapels 11. Somit entstehen im Grenzbereich zwischen dem Teilstapel 11 und dem weiteren Teilstapel 12 mechanische Spannungen, die zu einem Riss in oder an der Verbindungsschicht 13 führen. Es bildet sich der Entlastungsriss. Anschließend wird der Gesamtstapel polarisiert, d.h. auch die Elektrodenschichten 122 des weiteren Teilstapels 12 werden elektrisch angesteuert.

Alternativ zum aufgezeigten Polarisierungsverfahren wird in einem ersten Schritt der Gesamtstapel polarisiert. Es werden die Elektrodenschichten 112 des Teilstapels 11 und die Elektrodenschichten 122 des weiteren Teilstapels 12 elektrisch angesteuert. Anschließend wird einer der Teilstapel 11 oder 12 depolarisiert. Dies führt zu unterschiedlichen Längenänderung des Teilstapels 11 und des weiteren Teilstapels 12 und somit zum Aufbau der mechanischen Spannungen, die zum Entlastungsriss der Verbindungsschicht 13 führen.

Weitere Ausführungsformen ergeben sich dadurch, dass während des Polarisierens des Teilstapels 11, des Polarisierens des Gesamtstapels 10 und/oder beim Depolarisieren eine Druckspannung in Stapelrichtung 101 des Gesamtstapels 10 angelegt wird.

Dieser neuen Piezoaktor 1 wird zur Ansteuerung eines Einspritzventils eines Motors eines Kraftfahrzeugs verwendet.

## Patentansprüche

1. Verfahren zum Herstellen eines Piezoaktors (1) in monolithischer Vielschichtbauweise, aufweisend
- einen Teilstapel (11) und
- mindestens einen weiteren Teilstapel (12), wobei
- jeder der Teilstapel übereinander angeordnete Piezokeramikschichten (111, 121) und zwischen den Piezokeramikschichten angeordnete Elektrodenschichten (112, 122) aufweist,
- sich jede der Elektrodenschichten (112, 122) des jeweiligen Teilstapels (11, 12) an mindestens einen von mindestens zwei seitlichen Oberflächenabschnitten (104) des Teilstapels erstreckt,
- an den seitlichen Oberflächenabschnitten des jeweiligen Teilstapels Außenmetallisierungen derart angeordnet und mit den Elektrodenschichten des Teilstapels verbunden sind, dass übereinander benachbart angeordnete Elektrodenschichten des Teilstapels mittelbar über die Außenmetallisierungen mit unterschiedlichen elektrischen Potentialen beaufschlagt werden können,
- die Teilstapel übereinander zu einem monolithischen Gesamtstapel angeordnet sind und
- die Teilstapel mit Hilfe mindestens einer zwischen den Teilstapeln angeordneten Verbindungsschicht miteinander verbunden sind,
mit folgenden Verfahrensschritten:
a) Bereitstellen des Gesamtstapels und
b) Erzeugen eines Entlastungsrisses der Verbindungsschicht, **dadurch gekennzeichnet, dass** zum Erzeugen des Entlastungsrisses folgende weiteren Verfahrensschritte durchgeführt werden:
c) Polarisieren des Teilstapels und
d) Polarisieren des weiteren Teilstapels,
wobei während des Polarisierens des Teilstapels und/oder während des Polarisierens des weiteren Teilstapels eine Druckspannung am Gesamtstapel angelegt wird.

2. Verfahren nach Anspruch 1, wobei während des Polarisierens des Teilstapels die Elektrodenschichten des weiteren Teilstapels kurzgeschlossen werden.

3. Verfahren nach einem der Ansprüche 1 oder 2, wobei zum Polarisieren des Teilstapels und/oder zum Polarisieren des weiteren Teilstapels ein Teilpolarisieren durchgeführt wird

4. Verfahren zum Herstellen eines Piezoaktors (1) in monolithischer Vielschichtbauweise, aufweisend
- einen Teilstapel (11) und
- mindestens einen weiteren Teilstapel (12), wobei
- jeder der Teilstapel übereinander angeordnete Piezokeramikschichten (111, 121) und zwischen den Piezokeramikschichten angeordnete Elektrodenschichten (112, 122) aufweist,
- sich jede der Elektrodenschichten (112, 122) des jeweiligen Teilstapels (11, 12) an mindestens einen von mindestens zwei seitlichen Oberflächenabschnitten (104) des Teilstapels erstreckt,
- an den seitlichen Oberflächenabschnitten des jeweiligen Teilstapels Außenmetallisierungen derart angeordnet und mit den Elektrodenschichten des Teilstapels verbunden sind, dass übereinander benachbart angeordnete Elektrodenschichten des Teilstapels mittelbar über die Außenmetallisierungen mit unterschiedlichen elektrischen Potentialen beaufschlagt werden können,
- die Teilstapel übereinander zu einem monolithischen Gesamtstapel angeordnet sind und
- die Teilstapel mit Hilfe mindestens einer zwischen den Teilstapeln angeordneten Verbindungsschicht miteinander verbunden sind,
mit folgenden Verfahrensschritten:
a) Bereitstellen des Gesamtstapels und
b) Erzeugen eines Entlastungsrisses der Verbindungsschicht, **dadurch gekennzeichnet, dass** zum Erzeugen des Entlastungsrisses folgende weiteren Verfahrensschritte durchgeführt werden:
e) Polarisieren des Gesamtstapels und
f) Depolarisieren eines der Teilstapel.

5. Verfahren nach Anspruch 4, wobei während des Polarisierens des Gesamtstapels und/oder während des Depolarisierens eines der Teilstapel eine Druckspannung am Gesamtstapel angelegt wird.

6. Piezoaktor in monolithischer Vielschichtbauweise,
aufweisend
- einen Teilstapel (11) und
- mindestens einen weiteren Teilstapel (12), wobei
- jeder der Teilstapel übereinander angeordnete Piezokeramikschichten (111, 121) und zwischen den Piezokeramikschichten angeordnete Elektrodenschichten (112, 122) aufweist,
- sich jede der Elektrodenschichten des jeweiligen Teilstapels an mindestens einen von mindestens zwei seitlichen Oberflächenabschnitten (104) des Teilstapels erstreckt,
- an den seitlichen Oberflächenabschnitten des jeweiligen Teilstapels Außenmetallisierungen derart angeordnet und mit den Elektrodenschichten des Teilstapels verbunden sind, dass übereinander benachbart angeordnete Elektrodenschichten des Teilstapels mittelbar über die Außenmetallisierungen mit unterschiedlichen elektrischen Potentialen beaufschlagt werden können,
- die Teilstapel übereinander zu einem monolithischen Gesamtstapel angeordnet sind,
- die Teilstapel mit Hilfe mindestens einer zwischen den Teilstapeln angeordneten Verbindungsschicht miteinander verbunden sind, und
- die Verbindungsschicht einen Entlastungsriss aufweist, **dadurch gekennzeichnet, dass**
- die Außenmetallisierungen der Teilstapel Außenmetallisierungsbereiche des Gesamtstapels bilden, die durch die Verbindungsschicht voneinander getrennt sind, und
- Außenmetallisierungsbereiche, mit deren Hilfe Elektrodenschichten der Teilstapel mit gleichen elektrischen Potentialen beaufschlagt werden sollen, über ein elektrisches Überbrückungsmittel elektrisch leitend miteinander verbunden sind.

7. Piezoaktor nach Anspruch 6, wobei zumindest einer der Teilstapel eine aus dem Bereich von einschließlich 1 mm bis einschließlich 10 mm und insbesondere eine aus dem Bereich von einschließlich 3 mm bis einschließlich 5 mm ausgewählte Teilstapelhöhe (113, 123) aufweist.

8. Piezoaktor nach Anspruch 6 oder 7, wobei der Gesamtstapel eine Gesamtstapelhöhe (103) aufweist, die aus dem Bereich von einschließlich 10 mm bis einschließlich 200 mm ausgewählt ist.

9. Verwendung eines Piezoaktors nach einem der Ansprüche 6 bis 8 zur Ansteuerung eines Ventils und insbesondere eines Einspritzventils einer Brennkraftmaschine.

## Claims

1. Method for producing a monolithic multilayer piezo actuator (1), featuring
- a stack element (11) and
- at least one further stack element (12), with
- each of the stack elements featuring piezoceramic layers (111, 121) arranged above one another and electrode layers (112, 122) arranged between the piezoceramic layers,
- each of the electrode layers (112, 122) of the respective stack element (11, 12) extending to at least one of at least two side surface sections (104) of the stack element,
- external metallisations being arranged on the side surface sections of the respective stack element and being connected to the electrode layers of the stack element, so that different electrical potentials can be applied directly to the electrode layers of the stack elements arranged adjacently above one another via the external metallisations,
- the stack elements are arranged above one another into a monolithic total stack and
- the stack elements are connected to each other with the aid of at least one connecting layer arranged between the stack elements,
with the following method steps:
a) Preparation of the total stack and
b) Creation of a load-relieving crack of the connecting layer **characterised in that** the following further method steps are executed to create the load-relieving crack:
c) Polarisation of the stack element and
d) Polarisation of the further stack element,
with a compressive stress being applied during the polarisation of the stack element and/or during the polarisation of the further stack element.

2. Method according to claim 1, with the electrode layers of the further stack element being short-circuited during the polarisation of the stack element.

3. Method according to one of claims 1 or 2, with a part polarisation being carried out for polarisation of the stack element and/or for polarisation of the further stack element.

4. Method for producing a monolithic multilayer piezo actuator (1), featuring
- a stack element (11) and
- at least one further stack element (12), with
- each of the stack elements featuring piezoceramic layers (111, 121) arranged above one another and electrode layers (112, 122) arranged between the piezoceramic layers,
- each of the electrode layers (112, 122) of the respective stack element (11, 12) extending to at least one of at least two side surface sections (104) of the stack element,
- external metallisations being arranged on the side surface sections of the respective stack element and being connected to the electrode layers of the stack element, so that different electrical potentials can be applied directly to the electrode layers of the stack elements arranged adjacently above one another via the external metallisations,
- the stack elements being arranged above one another into a monolithic total stack and
- the stack elements being connected to each other with the aid of at least one connecting layer arranged between the stack elements,
with the following method steps:
a) Preparation of the total stack and
b) Creation of a load-relieving crack of the connecting layer **characterised in that** the following further method steps are executed to create the load-relieving crack:
e) Polarisation of the stack element and
f) Depolarisation of one of the stack elements.

5. Method according to claim 4, with a compressive stress being applied to the total stack during the polarisation of the total stack and/or during the depolarisation of one of the stacks.

6. Monolithic multilayer piezo actuator, featuring
- a stack element (11) and
- at least one further stack element (12),
with
- each of the stack elements featuring piezoceramic layers (111, 121) arranged above one another and electrode layers (112, 122) arranged between the piezoceramic layers,
- each of the electrode layers of the respective stack element extending to at least one of at least two side surface sections (104) of the stack element,
- external metallisations being arranged on the side surface sections of the respective stack element and being connected to the electrode layers of the stack element, so that different electrical potentials can be applied directly to the electrode layers of the stack elements arranged adjacently above one another via the external metallisations,
- the stack elements being arranged above one another into a monolithic total stack
- the stack elements being connected to each other with the aid of at least one connecting layer arranged between the stack elements and
the connecting layer featuring a load-relieving crack,
**characterised in that**
- the external metallisations of the stack elements form external metallisation regions of the total stack which are separated from each other by the connecting layer, and
- external metallisation regions, with the aid of which the same electrical potentials are to be applied to electrode layers of the stack element, are connected electrically-conductively to each other via electrical bridging means.

7. Piezo actuator according to claim 6, with at least one of the stack elements having a stack element height (113, 123) selected from the range 1 mm up to and including 10 mm and especially from the range 3 mm up to and including 5 mm.

8. Piezo actuator according to claim 6 or 7, with the total stack having a total stack height (103) selected from the range 10 mm up to and including 200 mm.

9. Use of a piezo actuator according to one of the claims 6 to 8 for activation of a valve and especially of an injection valve of an internal combustion engine.

## Revendications

1. Procédé de fabrication d'un actionneur piézoélectrique (1) de type multicouche monolithique, comprenant
- une section d'empilement (11) et
- au moins une autre section d'empilement (12),
- chacune des sections d'empilement comprenant des couches piézocéramiques (111, 121) superposées et des couches d'électrode (112, 122) situées entre les couches piézocéramiques,
- chacune des couches d'électrode (112, 122) de la section d'empilement (11, 12) respective s'étendant sur au moins l'une d'au moins deux portions de surface latérales (104) de la section d'empilement,
- des métallisations extérieures étant situées sur les portions de surface latérales de la section d'empilement respective et étant reliées aux couches d'électrode de la section d'empilement de manière à ce que des couches d'électrode superposées contiguës de la section d'empilement puissent être alimentées indirectement avec des potentiels électriques différents par le biais des métallisations extérieures,
- les sections d'empilement étant superposées pour former un empilement complet monolithique et
- les sections d'empilement étant reliées les unes aux autres à l'aide d'au moins une couche de liaison située entre les sections d'empilement,
comprenant les étapes de procédé suivantes :
a) préparation de l'empilement complet et
b) production d'une fente de délestage de la couche de liaison,
**caractérisé en ce que** les étapes de procédé supplémentaires suivantes sont exécutées pour produire la fente de délestage :
c) polarisation de la section d'empilement et
d) polarisation de l'autre section d'empilement,
une contrainte de compression étant appliquée à l'empilement complet pendant la polarisation de la section d'empilement et/ou pendant la polarisation de l'autre section d'empilement.

2. Procédé selon la revendication 1, les couches d'électrode de l'autre section d'empilement étant court-circuitées pendant la polarisation de la section d'empilement.

3. Procédé selon l'une des revendications 1 ou 2, une polarisation partielle étant exécutée pour polariser la section d'empilement et/ou pour polariser l'autre section d'empilement.

4. Procédé de fabrication d'un actionneur piézoélectrique (1) de type multicouche monolithique, comprenant
- une section d'empilement (11) et
- au moins une autre section d'empilement (12),
- chacune des sections d'empilement comprenant des couches piézocéramiques (111, 121) superposées et des couches d'électrode (112, 122) situées entre les couches piézocéramiques,
- chacune des couches d'électrode (112, 122) de la section d'empilement (11, 12) respective s'étendant sur au moins l'une d'au moins deux portions de surface latérales (104) de la section d'empilement,
- des métallisations extérieures étant situées sur les portions de surface latérales de la section d'empilement respective et étant reliées aux couches d'électrode de la section d'empilement de manière à ce que des couches d'électrode superposées contiguës de la section d'empilement puissent être alimentées indirectement avec des potentiels électriques différents par le biais des métallisations extérieures,
- les sections d'empilement étant superposées pour former un empilement complet monolithique et
- les sections d'empilement étant reliées les unes aux autres à l'aide d'au moins une couche de liaison située entre les sections d'empilement,
comprenant les étapes de procédé suivantes :
a) préparation de l'empilement complet et
b) production d'une fente de délestage de la couche de liaison,
**caractérisé en ce que** les étapes de procédé supplémentaires suivantes sont exécutées pour produire la fente de délestage :
e) polarisation de l'empilement complet et
f) dépolarisation de l'une des sections d'empilement.

5. Procédé selon la revendication 4, une contrainte de compression étant appliquée à l'empilement complet pendant la polarisation de l'empilement complet et/ou pendant la dépolarisation de l'une des sections d'empilement.

6. Actionneur piézoélectrique de type multicouche monolithique, comprenant
- une section d'empilement (11) et
- au moins une autre section d'empilement (12),
- chacune des sections d'empilement comprenant des couches piézocéramiques (111, 121) superposées et des couches d'électrode (112, 122) situées entre les couches piézocéramiques,
- chacune des couches d'électrode de la section d'empilement respective s'étendant sur au moins l'une d'au moins deux portions de surface latérales (104) de la section d'empilement,
- des métallisations extérieures étant situées sur les portions de surface latérales de la section d'empilement respective et étant reliées aux couches d'électrode de la section d'empilement de manière à ce que des couches d'électrode superposées contiguës de la section d'empilement puissent être alimentées indirectement avec des potentiels électriques différents par le biais des métallisations extérieures,
- les sections d'empilement étant superposées pour former un empilement complet monolithique,
- les sections d'empilement étant reliées les unes aux autres à l'aide d'au moins une couche de liaison située entre les sections d'empilement et
- la couche de liaison étant pourvue d'une fente de délestage,
**caractérisé en ce que**
- les métallisations extérieures des sections d'empilement forment des zones de métallisation extérieure de l'empilement complet qui sont séparées les unes des autres par la couche de liaison et
- des zones de métallisation extérieure à l'aide desquelles des couches d'électrode des sections d'empilement doivent être alimentées avec des potentiels électriques identiques sont reliées les unes aux autres de manière électroconductrice par le biais d'un moyen de pontage électrique.

7. Actionneur piézoélectrique selon la revendication 6, au moins l'une des sections d'empilement ayant une hauteur de section d'empilement (113, 123) choisie dans la gamme allant de 1 mm inclus à 10 mm inclus et, notamment, une hauteur choisie dans la gamme allant de 3 mm inclus à 5 mm inclus.

8. Actionneur piézoélectrique selon la revendication 6 ou 7, l'empilement complet ayant une hauteur d'empilement complet (103) qui est choisie dans la gamme allant de 10 mm inclus à 200 mm inclus.

9. Utilisation d'un actionneur piézoélectrique selon l'une des revendications 6 à 8 pour commander une soupape et notamment une soupape d'injection d'un moteur à combustion interne.
